Europäisches Patentamt

European Patent Office

Office européen des brevets

(11) Veröffentlichungsnummer: **0 098 325 B1**

# (12) EUROPÄISCHE PATENTSCHRIFT

(45) Veröffentlichungstag der Patentschrift:
12.04.89

(21) Anmeldenummer: 82106136.3

(22) Anmeldetag: 08.07.82

(51) Int. Cl.⁴: **G 06 F 7/72, G 06 F 7/56, H 03 M 7/18**

(54) Optisches Rechenwerk, Vorrichtung zur Umwandlung von Residuenzahlen in positionsnotierte Zahlen.

Teilanmeldung 88110312 eingereicht am 28.06.88.

(30) Priorität: 08.07.81 DE 3126987
07.07.82 DE 3225404

(43) Veröffentlichungstag der Anmeldung:
18.01.84 Patentblatt 84/3

(45) Bekanntmachung des Hinweises auf die Patenterteilung:
12.04.89 Patentblatt 89/15

(84) Benannte Vertragsstaaten:
AT DE FR GB

(56) Entgegenhaltungen:
US-A- 3 990 072

APPLIED OPTICS, Band 18, Nr. 2, Januar 1979, Seiten 149-162, New York, US; A. HUANG et al.: "Optical computation using residue arithmetic"

(73) Patentinhaber: Siemens Aktiengesellschaft Berlin und München, Wittelsbacherplatz 2, D-8000 München 2 (DE)

(72) Erfinder: Schuöcker, Dieter, Prof. Dr.,
Veltingergasse 30/5, A-1130 Wien (AT)
Erfinder: Klement, Ekkehard, Dr., Siegrunestrasse 1,
D-8000 München 19 (DE)

## Beschreibung

Die Erfindung betrifft eine Vorrichtung zum Addieren von in ihrer Residuendarstellung in bezug auf eine Anzahl vorbestimmter Moduln dargestellten Zahlen nach dem Oberbegriff des Patentanspruchs 1 und wie sie aus der US-A-3 990 072 hervorgeht.

Die bekannte Vorrichtung ist eine akustische Vorrichtung, die im Zeitraum arbeitet, d. h. es werden aus den parallelen Strukturen simultan Signale seriell ausgelesen und einander überlagert und dann auf die zeitliche Lage eines Signalmaximums in bezug auf einen zeitlichen Nullpunkt abgetastet.

Aufgabe der Erfindung ist es, eine Vorrichtung der genannten Art dahingehend zu verbessern, daß das Ergebnis der Addition sofort und nicht erst nach einer gewissen Zeit am Ausgang der Vorrichtung zur Verfügung steht.

Diese Aufgabe wird durch die im kennzeichnenden Teil des Patentanspruchs 1 angegebenen Merkmale gelöst.

In der Regel wird die erfindungsgemäße Vorrichtung bei einem optischen Rechenwerk für die elementaren Rechenoperationen in Residuendarstellung eingesetzt.

Ein beispielhaftes solches Rechenwerk besteht z.B. aus einer Einrichtung, die zwei binäre und durch je einen Lichtweg pro Binärstelle parallel übertragene Zahlen in ihre Residuendarstellung umwandelt und aus einer Vorrichtung, die zwei in Residuendarstellung vorliegende Zahlen addiert und in eine binär oder dezimal kodierte Zahl umwandelt.

Die Umwandlung einer Binärzahl in ihre Residuendarstellung ist sehr einfach, wenn man die Addition von Residuenzahlen beherrscht, weil man ja nur die Residuen der Gewichte aller jener Binärstellen addieren muß, die den binären Wert oder die Ziffer «1» aufweisen.

Die beiden restlichen Vorgänge der Addition zweier beliebiger Residuenzahlen innerhalb des Bereichs $0 < \prod_{i=1}^{N} M_i$ und der Umwandlung der Ergebnisse in eine Binär- oder Dezimalzahl stellen die wichtigsten Probleme bei der Verwirklichung der erfindungsgemäßen optischen Vorrichtung dar.

Es sei darauf hingewiesen, daß bereits aus Appl. Otpics 18 (1979) Seiten 163–171 eine Vorrichtung zur Umwandlung von der Residuendarstellung in Dezimaldarstellung bekannt geworden ist, bei der die Umwandlung durch zwei räumliche Fourier-Transformationen mittels Linsen und einem Gitter erfolgt, wobei die umgewandelte Zahl in dezimaler Positionsnotation, also an der Lage eines Lichtstrahls relativ zu einem linearen Maßstab abgelesen werden kann.

Derartige Anordnungen mit diskreten optischen Bauelementen, wie Linsen und Gittern, eignen sich allerdings nicht für eine planare Integration, wie sie für moderne Rechenbausteine in komplexen Systemen erwünscht ist.

Die erfindungsgemäße Vorrichtung ermöglicht dagegen eine planare Integration. Sie läßt sich aber auch mit diskreten Bauelementen realisieren.

Eine mit diskreten Bauelementen gebildete Ausführungsform, die im wesentlichen rein mechanisch arbeitet, geht aus dem Anspruch 2 hervor.

Andere Ausführungsformen, die rein optisch arbeiten und sowohl diskret als auch in planarer Integration ausführbar sind, gehen aus den übrigen Ansprüchen hervor. Diese Ausführungsformen erlauben extrem hohe Rechengeschwindigkeiten.

Bei einer Vorrichtung nach Anspruch 8 reicht es für viele Zwecke aus, das Interferenzmuster so zu erzeugen, wie es im Anspruch 9 angegeben ist. Insbesondere für eine scharfe Markierung der positionsnotierten Zahlen ist es aber zweckmäßig, die im Anspruch 10 angegebenen Maßnahmen zu ergreifen. Dabei wird vorteilhafterweise so vorgegangen, wie es im Anspruch 11 angegeben ist.

Besondere Ausgestaltungen einer Vorrichtung nach Anspruch 8 gehen aus den Ansprüchen 12 bis 19 hervor.

Ein besonderer Vorteil einer erfindungsgemäßen Vorrichtung liegt darin, daß die Residuenzahlen zugleich dekodiert werden, so daß diese Vorrichtung auch als Vorrichtung zur Umwandlung einer Residuenzahl in eine anders kodierte Zahl verwendet werden kann. Dadurch kann aber ein äußerst schnelles und einfach aufgebautes optisches Rechenwerk geschaffen werden, bei welchem die Vorrichtung zur Umwandlung von Residuenzahlen in positionsnotierte Zahlen zugleich einen optischen Addierer für Residuenzahlen bildet.

Eine erfindungsgemäße Vorrichtung wird so betrieben, daß die periodischen Strukturen entsprechend den vorgegebenen und zugeordneten Residuenwerten bzw. Summen dieser Werte aus einer ursprünglichen Phasenlage verschoben werden und das Ergebnis dort entnommen wird, wo Phasen der einzelnen Strukturen, die vor der Verschiebung zusammengefallen sind, nach der Verschiebung zusammenfallen.

Die Erfindung wird anhand der beigefügten Figuren in der nun folgenden Beschreibung näher erläutert. Von den Figuren zeigen:

Figur 1 einen Ausschnitt aus einer Vorrichtung, die zur Umwandlung von Residuenzahlen in positionsnotierte Zahlen geeignet ist, die aber praktisch schwer realisierbar ist,

Figur 2 in schematischer Darstellung eine Ausführungsform einer erfindungsgemäßen Vorrichtung,

Figur 3 eine Realisierung einer Vorrichtung nach Figur 2, bei der die periodischen Strukturen durch stehende Lichtwellen in Streifenleitern erzeugt werden,

Figur 4 in schematischer Darstellung eine andere Realisierung einer Vorrichtung nach Figur 2, bei der die periodischen Strukturen durch Interferenzmuster realisiert werden,

Figur 5 eine Ausführungsform eines erfindungsgemäßen Addierers, der im wesentlichen so aufgebaut ist, wie die Vorrichtung nach Figur 3,

Figur 6 eine Ausführungsform einer Vorrichtung, die im wesentlichen so aufgebaut ist, wie die
Vorrichtung nach Figur 4,

Figur 7 eine Vorrichtung zur Umwandlung von
Residuenzahlen in eine binär kodierte Darstellung,

Figur 8 eine andere Ausführungsform einer erfindungsgemäßen Vorrichtung,

Figur 9 eine Vorrichtung zur Umwandlung einer
Binärzahl in eine deren Wert entsprechende Phasenänderung in einem die Vorrichtung durchstrahlenden Laserstrahl, und

Figur 10 einen optischen Addierer für Dualzahlen, der das Ergebnis als positionsnotierte Zahl
ausgibt.

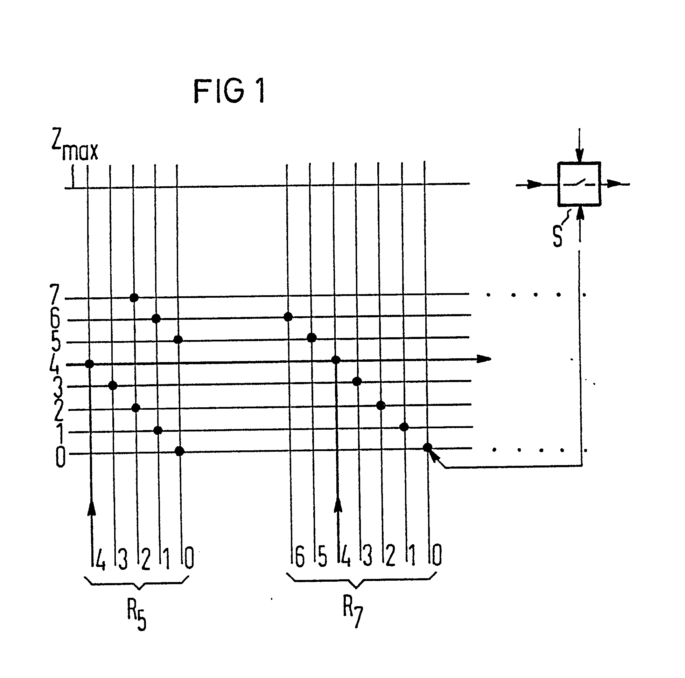

Es wird zunächst näher auf die Umwandlung
von Residuenzahlen in positionsnotierte Dezimalzahlen eingegangen. Die Umwandlung von
Residuenzahlen $R_1...R_n$ in Dezimalzahlen Z kann
bei Positionsnotation grundsätzlich durch eine
rechteckige Matrix aus Lichtwegen erfolgen. In
der Figur 1 ist eine derartige Matrix schematisch
dargestellt, in der sowohl die horizontalen als
auch die vertikalen Linien jeweils Lichtwege bedeuten. Die horizontalen Linien repräsentieren
die Dezimalzahlen. Gruppen von vertikalen Linien
repräsentieren die Residuen. Jede Gruppe vertikaler Linien steht für einen Modul $M_i$ und weist
genau $M_i$ vertikale Leitungen auf.

Wenn in denjenigen Schnittpunkten von Leitungen, für die $Z_n = nM_1 + R_i$, i = 1, 2, . . . , N erfüllt
ist, ein Schalter in der horizontalen Leitung durch
die vertikale Leitung betätigt wird, so bewirkt die
Aktivierung derjenigen vertikalen Leitungen, die
den vorliegenden Residuenwerten entsprechen,
daß in jeder Gruppe von vertikalen Leitungen alle
Schalter geschlossen werden, die in denjenigen
horizontalen Leitungen liegen, für die $Z_n = nN_i +$
$R_i$ gilt. Diejenige horizontale Leitung, in der alle
Schalter geschlossen sind, entspricht dann der
resultierenden Dezimalzahl die alle Gleichungen
$Z = n_1M_1 + R_1 = n_2M_2 + R_2 = ... = NM_N + R_N$
erfüllt.

In der Figur 1 ist nur ein Ausschnitt aus einer
vollständigen Matrix gezeichnet, und zwar sind
nur die horizontalen Leitungen, welche die positionsnotierten Zahlen 0 bis 7 und am oberen Ende
noch die maximale positionsnotierte Zahl $Z_{max}$ bezeichnen. Von den Gruppen vertikaler Leitungen
sind nur zwei Gruppen dargestellt, welche den
beiden Primzahlmoduli $M_1 = 5$ und $M_2 = 7$ zugeordnet sind. Die dem Primzahlmodul 5 zugeordnete Gruppe weist fünf vertikale Leitungen auf, welche den fünf möglichen Residuen 0 bis 4 zugeordnet sind. Die zum Primzahlmodul 7 gehörige Gruppe weist sieben vertikale Leitungen auf, welche
den sieben möglichen Residuen 0 bis 6 zugeordnet sind. Ein mit einem schwarzen Punkt gekennzeichneter Schnittpunkt bedeutet, daß an dieser
Stelle ein Schaltelement vorgesehen ist, welches
über die vertikale Leitung auf und zu gesteuert
werden kann und welches die horizontale Leitung unterbricht oder schließt. Ein derartiges Schaltelement ist in der Figur 1 schematisch dargestellt
und mit S bezeichnet.

Wenn beispielsweise die in der elektronischen
Datenverarbeitung üblichen Binärzahlen mit
sechzehn Stellen in Residuendarstellung verarbeitet werden sollen, muß die soeben beschriebene Matrix rund 64 000 horizontale Leitungen, aber
nur etwa 100 vertikale Leitungen umfassen. Die
Lösung des Problems, derartig viele Lichtleiter in
ein optisches Bauelement zu packen, scheint mit
der derzeit verfügbaren Technologie der integrierten Optik noch nicht möglich zu sein. Die
erforderlichen Schaltelemente sind in so großer
Zahl nicht zu verpacken, insbesondere schon deshalb nicht, weil rein optische Schalter nicht existieren, sondern nach wie vor optoelektronisch
gearbeitet werden muß. Davon abgesehen ist
auch das Zusammenpacken einer so großen Zahl
von Leitungen auf engem Raum keineswegs unproblematisch.

Diese Probleme lassen sich mit der hier vorgeschlagenen Vorrichtung beseitigen.

Dieser Vorschlag benutzt die Erkenntnis, daß
die positionsnotierten Zahlen, beispielsweise Dezimalzahl wie bei der Figur 1, anstatt durch parallele Leitungen durch eine Anzahl von periodischen linearen Strukturen mit Periodenlängen,
die jeweils einem Primzahlmodul $M_i$ proportional
sind, beispielsweise durch lineare Strukturen Si, i
= 1 bis N mit periodischen Marken Ma, deren
Abstände Pi jeweils dem zugeordneten Primzahlmodul $M_i$ proportional sind, repräsentiert werden
können.

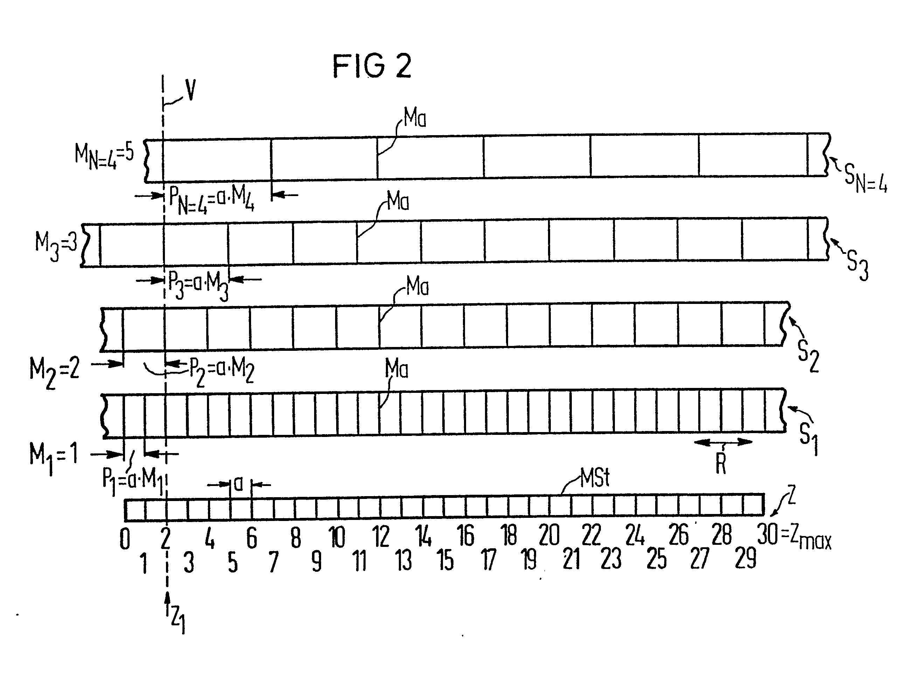

Die Figur 2 zeigt in schematischer Darstellung
eine Ausführungsform einer derartigen Vorrichtung. Bei dieser Vorrichtung ist vorausgesetzt,
daß die Residuendarstellung mit den Primzahlmoduln 1, 2, 3 und 5 erfolgt. Die maximale eindeutig
darstellbare Zahl ist dann gegeben durch $Z_{max} =$
30.

Die Reihe Z der Zahlen 0 bis 30 sind in der Figur
2 unten auf einem linearen Maßstab MSt positionsnotiert. Über dem linearen Maßstab MSt sind
parallel dazu vier periodische lineare Strukturen
$S_1, S_2, S_3$ und $S_{N=4}$ angeordnet, die relativ zueinander und längs des linearen Maßstabes MSt, also in
Richtung des Doppelpfeiles R, verschiebbar sind.

Die Strukturen $S_1$ bis $S_{N=4}$ weisen jeweils äquidistante Marken auf. Der Markenabstand $P_1$ der
Struktur $S_1$ entspricht ist gleich dem Primzahlmodul $M_1$ gewählt und damit gleich der durch den
Maßstab gegebenen Einheit a. Der Markenabstand $P_2$ der Struktur $S_2$ entspricht dem Primzahlmodul $M_2$ und damit der doppelten Einheit a. Der
Markenabstand $P_3$ der Struktur $S_3$ entspricht dem
Primzahlmodul $M_3$ und damit der dreifachen Einheit a. Schließlich entspricht der Markenabstand
$P_4$ der Struktur $S_4$ dem Primzahlmodul $M_4$ und
damit der fünffachen Einheit a.

Um mit der soeben beschriebenen Vorrichtung
eine gegebene Residuenzahl in eine positionsnotierte Zahl umzuwandeln, wird so vorgegangen,
daß die vier Strukturen $S_1$ bis $S_4$ in eine Lage
gebracht werden, daß Marken Ma sämtlicher Strukturen über der positionsnotierten Null übereinander, d.h. auf einer vertikalen Linie durch die positionsnotierte 0 liegen. Von dieser Nullstellung aus wird jede Struktur Si, i = 1 bis 4 soweit nach rechts verschoben, wie das ihrem Primzahlmodul Mi zugeordnete Residuum angibt. Die Stelle, bei der Marken Ma sämtlicher Strukturen, also insgesamt vier Marken Ma übereinander und damit auf einer vertikalen Linie liegen, zeigt die zu der betreffenden Residuenzahl gehörige positionsnotierte Zahl an. In der Figur 2 wird die positionsnotierte 2 angezeigt, weil genau vier Marken Ma auf einer durch die positionsnotierte 2 gehenden vertikalen Linie V liegen, die gestrichelt angedeutet ist.

Bei den vorausgesetzten Primzahlmoduln $M_1 = 1$, $M_2 = 2$, $M_3 = 3$ und $M_4 = 5$ gilt: $2 = 2 \cdot M_1 + 0 = 1 . M_2 + 0 = 0 . M_3 + 2 = 0 . M_5 + 2$. d.h., daß bei dieser Residuendarstellung 2 durch die Residuenzahl (0, 0, 2, 2) repräsentiert ist. Dies bedeutet, daß die Strukturen $S_1$ und $S_2$ aus ihrer Nullstellung nicht zu verschieben sind, während die Strukturen $S_3$ und $S_4$ um zwei Einheiten nach rechts zu verschieben sind. Führt man dies aus, so gibt sich die in Figur 2 dargestellte Konfiguration.

Eine praktische Realisierung der in Figur 2 dargestellten Vorrichtung ist beispielsweise die Überlagerung linearer Lochmasken, bei denen jede Marke Ma durch ein Loch oder Fenster repräsentiert ist. Eine Stelle $Z_1$, wo sämtliche Löcher Ma nach den durch die vorgegebene Residuenzahl vorgenommenen Verschiebungen zusammenfallen, wird die Vorrichtung durchsichtig und kennzeichnet auf diese Weise die zugeordnete positionsnotierte Zahl.

Da eine derartige Vorrichtung im wesentlichen mechanisch arbeitet, kommt sie für schnell arbeitende Rechenwerke nicht in Frage.

Die linearen periodischen Strukturen können aber auch mit optischen Mitteln, beispielsweise durch stehende Wellen realisiert werden. Die äquidistanten Marken sind dabei durch eine bestimmte Phase dieser stehenden Wellen realisiert, beispielsweise durch deren Knoten. Die Verschiebung der stehenden Wellen kann durch Phasenmodulatoren erfolgen, die vor den zur Erzeugung der stehenden Wellen erforderlichen Reflektoren angeordnet sind und die die Welle vor- und zurückschieben. Wenn durch Licht induzierte dispersive Effekte, wie etwa die Verringerung des Brechungsindex von III–V Halbleitern durch Zerstörung der Excitonen verwendet werden, dann kann der Modulator durch einen Lichtstrahl angesteuert werden und damit eine rein optische Anordnung realisiert werden.

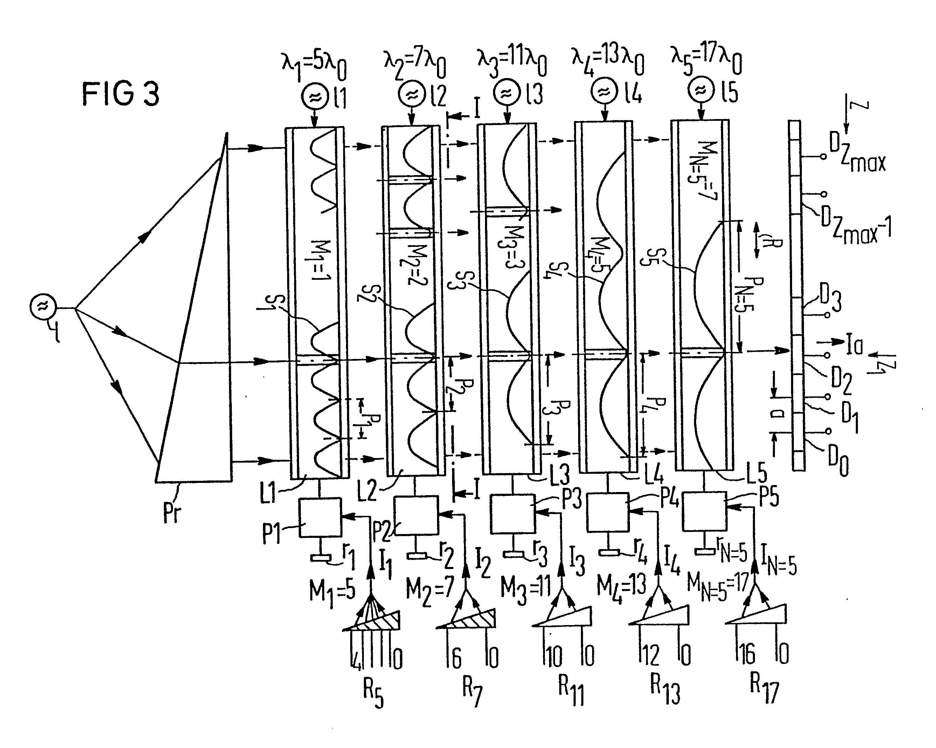

Die Figur 3 zeigt eine derartige Realisierung. Die stehenden Wellen werden bei dieser Realisierung in parallelen Streifenleitern L1 bis L5 erzeugt, die aus einem Material bestehen, das eine lichtinduzierte Beeinflussung des Brechungsindex erlaubt und deren Längsseiten teildurchlässig verspiegelt sind, damit sie in transversaler Richtung einen Fabry-Perot-Resonator bilden, der für kritische Werte des Brechungsindex in transversaler Richtung durchsichtig wird. Bei geeigneter Dimensionierung der Breite des Streifenleiters kann erreicht werden, daß die Struktur gerade dort, wo die Knoten der stehenden Welle liegen, transversal einfallendes Licht gut transmittiert und überall anders nur wenig durchläßt.

Zur Erzeugung der stehenden Wellen sind Lichtquellen I1 bis I5 vorgesehen, die Licht verschiedener Wellenlängen aussenden. Jede dieser Lichtquellen Ii, i = 1,2, . . . , N = 5 sendet eine Lichtwellenlänge $\lambda_i = M_i . \lambda_0$ aus. $M_i$ ist der der Lichtquelle Ii bzw. dem Streifenleiter Li zugeordnete Primzahlmodul. Dadurch entspricht der Knotenabstand Pi der im Streifenleiter Li erzeugten stehenden Welle dem zugeordneten Primzahlmodul $M_i$, so dass $a = \lambda_0$ gilt. Bei der in Figur 3 dargestellten Vorrichtung gilt speziell $M_1 = 5$, $M_2 = 7$, $M_3 = 11$, $M_4 = 13$ und $M_{N=5} = 17$. Die diesen Primzahlmoduln zugeordneten Residuen $R_1$, $R_2$, $R_3$, $R_4$ und $R_{N=5}$ können jeweils die Zahlen 0 bis 4, 0 bis 6, 0 bis 10, 0 bis 12, bzw. 0 bis 16 annehmen.

Die zur Erzeugung der stehenden Wellen erforderlichen Reflektoren sind in der Figur 3 mit $r_1$ bis $r_{N=5}$ bezeichnet. Zwischen jedem Streifenleiter Li und dem ihm zugeordneten Reflektor $r_i$ ist ein Phasenmodulator Pi, i = 1 bis N = 5 angeordnet, der durch einen Lichtstrahl $I_i$ gesteuert wird. Die durch einen derartigen Phasenmodulator erzeugte Phasenverschiebung ist um so größer, je größer die Intensität des steuernden Lichtstrahles ist.

Die Intensität eines steuernden Lichtstrahles muß stufenweise verändert werden können, und zwar entsprechend den möglichen Residuenwerten. So muss beispielsweise der Lichtstrahl $I_1$ in fünf Intensitätsstufen verändert werden können, die den Residuenwerten 0, 1, ... 4 des Residuums $R_5$ entsprechen. Analoges gilt für die anderen steuernden Lichtstrahlen $I_2$ bis $I_5$. Die stufenweise Veränderung der Intensität kann durch Überlagerung einzelner Lichtstrahlen erfolgen, wie es in der Figur 3 angedeutet ist.

Die Streifenleiter Li werden mit einer von einer Lichtquelle 1 und einem Prisma Pr erzeugten ebenen Lichtwelle transversal bestrahlt. Die Streifenleiter sind für dieses Licht in den Knoten der in ihnen erzeugten stehenden Wellen lichtdurchlässig. Die ganze Wellenleiterstruktur ist aber für dieses Licht nur dort maximal durchlässig, wo Knoten sämtlicher Wellenleiter in Ausbreitungsrichtung der ebenen Wellen hintereinander angeordnet sind. Dies ist immer nur an einer bestimmten Stelle der Fall und diese Stelle $Z_1$, an der Licht aus der gesamten Wellenleiterstruktur austritt, gibt die zugeordnete positionsnotierte Zahl an.

Dazu kann beispielsweise ein Detektorfeld verwendet werden, welches $Z_{max} + 1$ lichtempfindliche Einzeldetektoren $D_0$ bis $D_{Zmax}$ aufweist. Bei dieser Bezeichnung der Einzeldetektoren kann die zugeordnete positionsnotierte Zahl gleich dem Index gesetzt werden. Die Vorrichtung nach Figur 3 zeigt beispielsweise die positionsnotierte Zahl 2 an, weil der Detektor $D_2$ maximal angeregt wird.

Die in Figur 3 dargestellte Vorrichtung eignet sich gut für die Realisierung mit den Mitteln der integrierten Optik und hat den beträchtlichen Vorteil, daß die Umwandlung durch die parallele Arbeitsweise sehr rasch erfolgt.

Die periodischen Strukturen können auch durch Interferenz, beispielsweise durch Zweistrahlinterferenz, erzeugt werden, bei der die Überlagerung zweier ebener Lichtwellen, deren Ausbreitungsrichtungen einen Winkel einschließen, in einer zur Ebene der beiden Ausbreitungsrichtungen senkrechten Ebene eine Amplitudenverteilung entsprechend einer stehenden Welle ergibt. Der Abstand $\Gamma$ der Interferenzstreifen ist durch die Wellenlänge $\lambda$ und den Winkel $\alpha$ zwischen den beiden Ausbreitungsrichtungen gegeben durch

$$\Gamma = \frac{\lambda}{2} \frac{1}{\sin(\alpha/2)\cos\beta}$$

der bei kleinen Winkeln $\alpha$ sehr groß wird. $\beta$ ist der Winkel zwischen der Beobachtungsebene und der Normalen auf die Winkelhalbierende von $\alpha$.

Die zur Darstellung der einzelnen Residuenwerte nötige Verschiebung der Interferenzstreifen kann durch einen Phasenmodulator erzeugt werden, der die Phasenlage eines der beiden Strahlen verschiebt.

Da für jeden der bei der Residuendarstellung verwendeten Primzahlmoduln ein derartiges Interferenzmuster erzeugt werden muß, dessen Streifenabstand dem zugeordneten Modul proportional ist, muß mit entsprechend vielen verschieden gerichteten Lichtstrahlen gearbeitet werden.

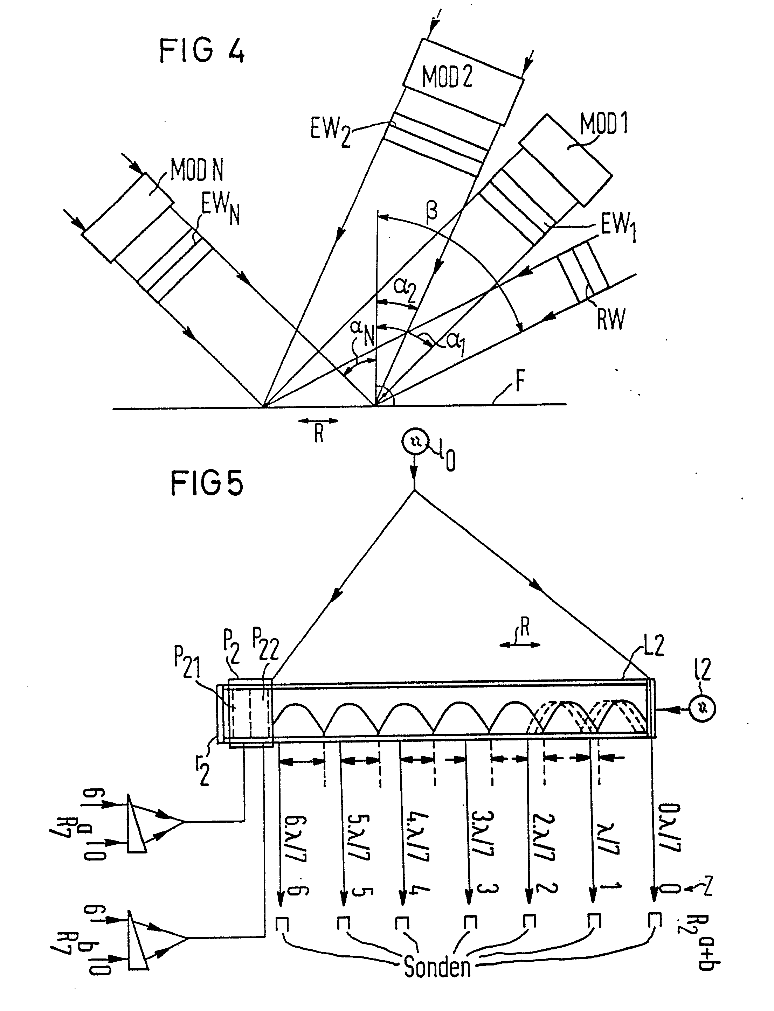

Die Figur 4 zeigt in schematischer Darstellung eine derartige Vorrichtung für Residuenzahlen $R_1$, $R_2$, ... $R_N$, die auf N Moduln $M_1$, $M_2$, ..., bzw. $M_N$ basieren. Zur Erzeugung der dafür notwendigen N Interferenzmuster werden N ebene Wellen $EW_1$, $EW_2$, ..., $EW_N$ verwendet, die unter N verschiedenen Einfallswinkeln $\alpha_1$, $\alpha_2$, ..., $\alpha_N$ mit einer Referenzwelle RW zur Interferenz gebracht werden. Dabei bildet sich in einer Ebene, die auf einer alle Ausbreitungsrichtungen enthaltenden und in der Figur 4 mit der Zeichenebene zusammenfallenden Ebene senkrecht steht, ein resultierendes Interferenzmuster aus, das der kohärenten Überlagerung von N + 1 Wellen entspricht. In der Ebene, in der das resultierende Interferenzmuster entsteht, ist ein Schirm F angeordnet. Jede der ebenen Wellen $EW_1$, $EW_2$, ..., $EW_N$ durchläuft je einen Phasenmodulator MOD1, MOD2, ..., MODN mit dem die Phasenlage der betreffenden Welle verschiebbar ist.

Werden die Phasenlagen der N einfallenden Wellen entsprechend den N gegebenen Residuenwerten verschoben, so werden auch die Streifen der N Interferenzmuster auf dem Schirm F verschoben und es kann auf einem darauf gedachten linearen Maßstab, die den Residuenwerten entsprechende positionsnotierte Zahl an der einzigen Stelle abgelesen werden, wo alle N Interferenzmuster ein gemeinsames Maximum aufweisen.

Die Auswertung kann beispielsweise und ähnlich wie bei der Vorrichtung gemäß Figur 3 mittels eines optoelektronischen Detektorfeldes erfolgen. Der Detektor, bei dem das Maximum liegt, gibt ein charakteristisches Signal ab, welches beispielsweise auf die zugeordnete positionsnotierte Zahl in irgendeiner kodierten Form zeigt.

Die Vorrichtung gemäß Figur 4 kann auch mit den Mitteln der integrierten Optik, beispielsweise durch N streifenförmige Lichtwellenleiter realisiert werden, die unter N spitzen Winkeln $\alpha_1$, $\alpha_2$, ..., $\alpha_N$ zu einem Referenzwellenleiter verlaufen und in denen je ein Modulator angeordnet ist.

Die Modulatoren MOD1, MOD2, ..., MODN müssen wie bei der Vorrichtung gemäß Figur 3 steuerbar sein, weil ja die räumliche Verschiebung jedes Interferenzmusters dem jeweils zugeordneten, aber veränderlichen Residuenwert proportional sein muß. Die Residuenwerte liegen meist in Positionsnotation vor und es kann daher jeder der genannten Modulatoren aus N hinereinander geschalteten Einzelmodulatoren bestehen, von denen jeder je eine der den möglichen Residuenwerten entsprechenden Phasenverschiebungen erzeugt.

Da bei optischen Recheneinheiten Zahlen und daher auch die einzelnen Residuenwerte in positionsnotierter Darstellung durch Lichtwege charakterisiert werden, ist es zweckmäßig, wenn sämtliche Einzelmodulatoren optisch steuerbar sind. Jeder der Lichtwege führt dann zu genau einem dieser Einzelmodulatoren und jeder Einzelmodulator ist so eingestellt, daß er genau die Phasenverschiebung erzeugt, die der positionsnotierten Zahl entspricht, die durch den Lichtweg bestimmt ist, der ihm zugeführt ist.

Diese spezielle optische Steuerung ist aber, obwohl sehr vorteilhaft, nicht notwendig erforderlich. Die Positionsnotation der möglichen Residuenwerte ist allein schon durch die räumliche Anordnung der Einzelmodulatoren und der den Residuenwerten zugeordneten Phasenverschiebungen gegeben, die sie bewirken. Bei vorgegebenem Residuenwert ist lediglich der zugeordnete Einzelmodulator in geeigneter Weise anzusteuern.

Wenn die Zweistrahlinterferenz nicht zu einem ausreichend scharfen oder zu einem sich nicht deutlich genug von der Umgebung abhebenden, gemeinsamen Maximum oder Minimum führt, wird zweckmäßigerweise anstelle der Zweistrahlinterferenz eine Vielstrahlinterferenz angewendet. Dazu eignet sich beispielsweise ein Fabry-Perot-Interferometer. Bei einem solchen Interferometer ist der Streifenabstand nicht wie bei der Zweistrahlinterferenz konstant, wenn ein ebener Schirm verwendet wird, sondern der Abstand nimmt bei den beispielsweise als konzentrische Ringe vorliegenden Streifen radial nach außen hin zu. Durch Verwendung eines geeignet gewölbten Schirmes kann der Streifenabstand aber wieder konstant gemacht werden.

Aus jeder der in Figur 3 oder 4 dargestellten Vorrichtungen läßt sich ein Addierer für Residuenzahlen konstruieren. Dazu muß statt einem Modulator je periodischer Struktur eine der Anzahl der zu addierenden Residuenzahlen entsprechende Zahl von Modulatoren vorhanden sein, die durch Signale anzusteuern sind, die den zu addierenden Residuen entsprechen. Außerdem ist neben jeder der periodischen Strukturen ein linearer Maßstab anzuordnen, der gedacht sein kann, und auf dem Zahlen positionsnotiert sind, die den möglichen Residuenwerten entsprechen.

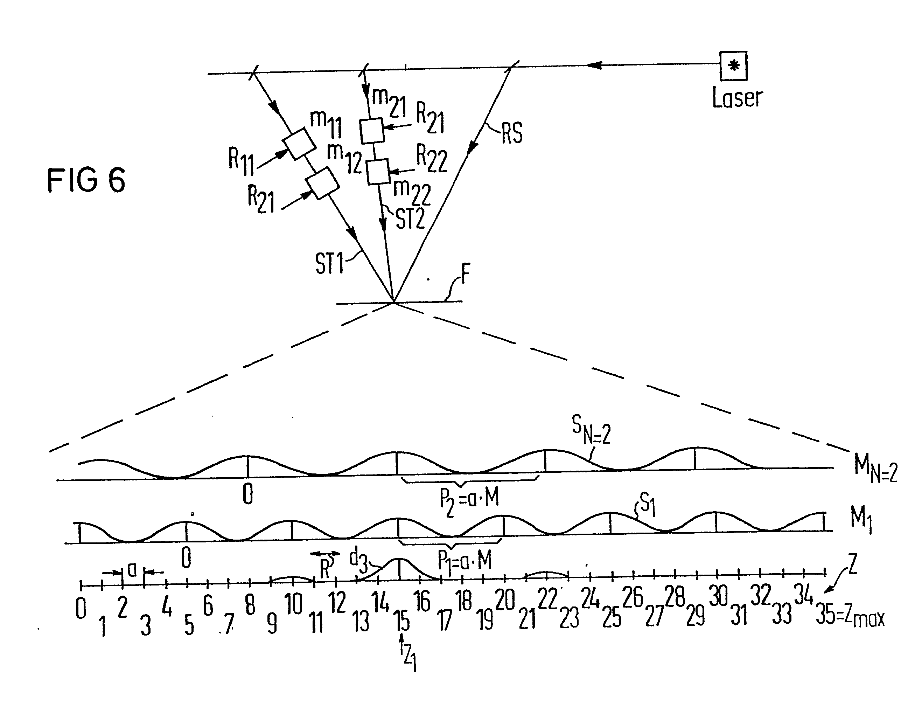

Eine erste Ausführungsform eines derartigen Addierers zeigt die Figur 5, die im wesentlichen der in Figur 3 dargestellten Struktur entspricht. Die Figur 5 stellt einen Querschnitt durch die in Figur 3 dargestellte Vorrichtung längs der Schnittlinie I–I dar. Unter dem Streifenleiter L2 sind Sonden angeordnet, welche die möglichen Residuenwerte 0 bis 6 des Residuums $R_2$ zum Primzahlmodul $M_2 = 7$ positionsnotieren. Der Abstand der Sonden voneinander ist dem siebten Teil der Wellenlänge der stehenden Welle im Wellenleiter proportional. Generell ist der Abstand zwischen benachbarten Sonden proportional zum Quotienten aus Periodenlänge einer Struktur und dem dieser Struktur zugeordneten Modul zu wählen. Unter jeder vorhandenen Struktur, und damit unter jedem der Streifenleiter L1 bis L5 sind derartig Sonden anzuordnen.

Ein wesentlicher Unterschied der in Figur 5 dargestellten Vorrichtung zu der in Figur 3 dargestellten besteht darin, daß jeder Modulator zwei Einzelmodulatoren aufweist, die getrennt durch zwei zu addierende Residuenwerte anzusteuern sind. In der Figur 5 steuert ein erster Residuenwert $R_2^a$ einen ersten Einzelmodulator P21 und ein zweiter Residuenwert $R_2^b$ den zweiten Einzelmodulator P22.

Beim Betrieb des Addierers wird dieser von oben mit einer Lichtquelle beleuchtet und in sämtlichen Streifenleitern werden stehende Wellen erzeugt. Die durch die beiden Modulatoren erzeugten Verschiebungen der stehenden Wellen entsprechen einer Gesamtverschiebung, die dem Summenwert $R_2^{a+b}$ der zu addierenden Residuen entspricht. Dieser Wert wird dadurch angezeigt, daß ein Knoten der stehenden Welle und damit eine durchsichtige Stelle des Streifenleiters genau über einer bestimmten Sonde liegt und dadurch Licht aus der Lichtquelle $L_0$ auf diese Sonde trifft. Die durch diese Sonde positionsnotierte Zahl entspricht dem Summenwert.

An sich genügt für diese Anordnung eine einzige Halbwelle. Zur Erhöhung der Genauigkeit kann aber auch für jeden Wert des Residuums die zugeordnete Sonde in einer anderen Halbwelle liegen, so wie es in der Figur 5 dargestellt ist. Der Addierer arbeitet vollkommen parallel und ist daher sehr schnell.

In der Figur 6 ist ein optischer Addierer dargestellt, welcher einer Vorrichtung nach Figur 4 entspricht, und der demnach mit Interferenz arbeitet.

Bei diesem Addierer werden ein Referenzstrahl RS, ein erster Strahl ST1 und ein zweiter Strahl ST2 die mit Hilfe von teildurchlässigen Spiegeln aus einem Laserstrahl abgezweigt werden, auf einem Schirm F zur Interferenz gebracht. In dem ersten Strahl ST1 sind zwei Phasenmodulatoren $m_{11}$, $m_{12}$ hintereinander angeordnet und dem zweiten Strahl ST2 zwei Phasenmodulatoren $m_{21}$ und $m_{22}$.

Dabei ist angenommen, daß zur Residuendarstellung zwei Moduln $M_1 = 5$ und $M_{N=2} = 7$ verwendet sind. Damit ist $Z_{max} = 35$.

Es sollen zwei Residuenzahlen $(R_{11}, R_{12}) = (1, 6)$ und $(R_{21}, R_{22}) = (4, 2)$ addiert werden. Diese beiden Residuenzahlen sind die Residuendarstellung der beiden Dezimalzahlen 6 bzw. 9.

Unter dem Schirm F sind in der Figur 6 schematisch Interferenzmuster über einem Maßstab dargestellt, auf dem die Zahlen 0 bis 35 äquidistant aufgetragen sind. Wegen der besseren Übersichtlichkeit sind die auftretenden Nebenmaxima weggelassen worden.

Die Kurve $S_{N=2}$ entspricht einem Interferenzmuster, welches von dem Strahl ST2 und dem Referenzstrahl RS auf dem Schirm F erzeugt wird. Der Streifenabstand $P_2$ dieses dem Modul $M_2$ zugeordneten Interferenzmusters beträgt sieben Maßstabseinheiten. Die beiden Modulatoren $m_{21}$ und $m_{22}$ bewirken eine Phasenverschiebung, die $R_{12} + R_{22}$ entspricht. Bei dem angegebenen Zahlenbeispiel entspricht dies acht Maßstabseinheiten. Das bedeutet, daß die Phasenlage des Interferenzmusters $S_{N=2}$ um acht Einheiten nach rechts verschoben ist. Die ursprünglich bei null und jetzt bei liegende Phase ist durch eine 0 gekennzeichnet.

Das durch den Strahl ST1 und den Referenzstrahl erzeugte Interferenzmuster, das dem Modul $M_1$ zugeordnet ist, ist durch die Kurve $S_1$ dargestellt. Bei diesem Muster entspricht der Streifenabstand $P_1$ fünf Maßstabseinheiten. Die Modulatoren $m_{11}$ und $m_{12}$ verschieben die Phasenlage des Interferenzmusters $S_1$ um $R_{11} + R_{21}$ nach rechts. Dies entspricht $1 + 4 = 5$ Maßstabseinheiten. Auch in diesem Interferenzmuster ist die ursprünglich bei null und jetzt bei 5 liegende Phase durch eine 0 gekennzeichnet.

In jedem der beiden Interferenzmuster $S_1$ und $S_{N=2}$ sind die Intensitätsmaxima durch die äquidistanten vertikalen Striche gekennzeichnet. Man entnimmt den beiden Mustern, daß bei der Zahl $Z_1 = 15$ die Maxima beider Interferenzmuster zusammenfallen. Das bedeutet, daß das tatsächliche Interferenzmuster, das durch alle drei Strahlen auf dem Schirm F erzeugt wird, dort ein absolutes Intensitätsmaximum aufweisen muß. Im Interferenzmuster $d_3$ ist dieses Maximum ebenfalls durch einen vertikalen Strich gekennzeichnet. Da die beiden Residuenzahlen den Dezimalzahlen 6 und 9 entsprechen, muß die Summe der Residuenzahlen der Dezimalzahl $9 + 6 = 15$ entsprechen, was tatsächlich der Fall ist.

Der in Figur 6 dargestellte Addierer ist somit zugleich ein optisches Rechenwerk, welches Residuenzahlen verarbeitet und die Ergebnisse in anders kodierter Form liefert. Somit bilden bei einem derartigen Rechenwerk die Recheneinheit, welche die Residuenzahlen verarbeitet und die Vorrichtung zur Umwandlung der Residuenzahlen in anders kodierte Zahlen eine Einheit.

Es sei darauf hingewiesen, daß der in Figur 6 dargestellte Addierer nur ein konkretes Beispiel darstellt, daß ein solcher Addierer aber auch durch die in Figur 3 und generell eine in Figur 2 dargestellte Vorrichtung oder einen entsprechenden Addierer realisiert werden kann.

Ein wesentlicher Vorteil eines derartigen Rechenwerks ist seine erhebliche Schnelligkeit.

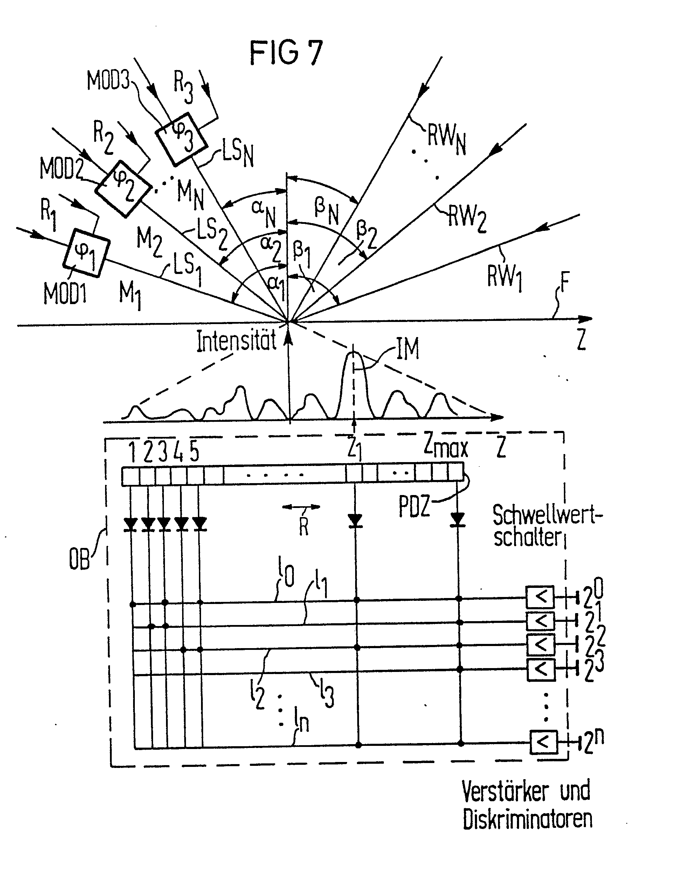

Aus der Figur 7 geht eine Vorrichtung zur Umwandlung von Residuenzahlen in eine binär kodierte Darstellung hervor. Diese Vorrichtung umfaßt eine Vorrichtung zur Umwandlung von Residuenzahlen in eine positionsnotierte Darstellung und eine elektronische Vorrichtung OB zur Umwandlung von positionsnotierten Zahlen in eine binär kodierte Darstellung.

Der Vorrichtung zur Umwandlung der Residuenzahlen in die positionsnotierte Darstellung liegt ähnlich wie bei der Figur 4 das Interferenzprinzip zugrunde.

In der Vorrichtung nach Figur 7 entsprechen die Laserstrahlen $LS_1$, $LS_2$, ..., $LS_N$ den ebenen Wellen $EW_1$, $EW_2$, ..., $EW_N$ in Figur 4 und sind dementsprechend den für die gewählte Residuendarstellung verwendeten Moduln $M_1$, $M_2$, ..., $M_N$ zugeordnet. Jeder dieser Laserstrahlen durchläuft, ähnlich wie bei der Vorrichtung gemäß Figur 4, je einen Phasenmodulator MOD1, MOD2, ..., MOD N. Ein Unterschied zur Vorrichtung nach Figur 4 besteht in der Verwendung mehrerer Referenzstrahlen-bzw. -wellen $RW_1$, $RW_2$, ..., $RW_N$. Darauf wird später noch eingegangen.

Wie bei der Vorrichtung gemäß Figur 4 entsteht auch bei der Vorrichtung nach Figur 7 in einer als Bezugsebene bezeichneten bestimmten Ebene F ein Interferenzmuster, dessen absolutes Maximum oder auch Minimum die der eingegebenen Residuenzahl entsprechende positionsnotierte Zahl anzeigt. Ein willkürliches Beispiel für ein solches Interferenzmuster, dessen absolutes Maximum bei der positionsnotierten Zahl $Z_1$ liegt, ist in der Figur 7 dargestellt und mit IM bezeichnet.

Die elektronische Vorrichtung zur Umwandlung von positionsnotierten Zahlen in binär kodierte Zahlen umfaßt eine Fotodiodenzeile PDZ zur Abtastung des linearen Interferenzmusters IM.

Jede einzelne Fotodiode der Fotodiodenzeile PDZ ist je eine der durch die gewählte Residuendarstellung möglichen positionsnotierten Zahlen 1, 2, ..., Z, ..., $Z_{max}$ zugeordnet. Jeder einzelnen Fotodiode ist je ein Schwellwertschalter nachgeschaltet, der nur dann ein Signal abgibt, wenn das absolute Maximum des Interferenzmusters auf die ihm zugeordnete Fotodiode fällt. Wie schon erwähnt, ist dies im Beispiel der Figur 7 für die Fotodiode bei Z der Fall.

Die dargestellte Vorrichtung OB zur Umwandlung von positionsnotierten Zahlen in eine binär kodierte Darstellung wandelt die positionsnotierten Zahlen in Dualzahlen um und besteht im wesentlichen aus parallelen Leitungen $l_1$, $l_2$, $l_3$ bis $l_n$, die wie folgt mit den Ausgängen der Schwellwertschalter verbunden sind:

Jede der Leitungen $l_0$, $l_1$, $l_2$, $l_3$, ..., $l_n$ repräsentiert je eine Stelle einer n + 1-stelligen Dualzahl $a_0 \cdot 2^0 + a_1 \cdot 2^1 + a_2 \cdot 2^2 + a_3 \cdot 2^3 + ... + a_n \cdot 2^n$ mit $a_i = 1$ oder 0, $i = 0, 1, 2, 3, ..., n$. $l_i$ ist in der Figur 7 der Stelle $2^i$ zugeordnet. Der Ausgang eines bestimmten Schwellwertschalters ist mit all den Leitungen $l_i$ verbunden, für welche die Koeffizienten $a_i$ der diesem bestimmten Schwellwertschalter zugeordneten positionsnotierten Zahl in der Dualzahlendarstellung 1 sind, während alle übrigen Leitungen, deren Koeffizienten 0 sind, nicht mit dem Ausgang des bestimmten Schwellwertschalters verbunden sind. Dies gilt für alle Schwellwertschalter und damit alle gegebenen positionsnotierten Zahlen.

Die Leitungen $l_i$ sind mit je einem Verstärker und Diskriminator verbunden. An den Ausgängen dieser Diskriminatoren sind die Dualzahlen parallel entnehmbar.

Wie schon erwähnt, unterscheidet sich die Vorrichtung nach Figur 7 zur Umwandlung von Residuenzahlen in eine linear positionsnotierte Darstellung von jener nach Figur 4, und zwar dadurch, daß für jeden Laserstrahl $LS_1$, $LS_2$, ..., $LS_N$ ein eigener Referenzstrahl $RW_1$, $RW_2$, ..., $RW_N$ anstelle von einem einzigen gemeinsamen Referenzstrahl RW vorgesehen ist. Durch diese Maßnahme kann erreicht werden, daß sich das die positionsnotierte Zahl anzeigende absolute Maximum oder auch Minimum des Interferenzmusters deutlicher hervortritt, zumindest gegen seine nähere Umgebung.

Der Einfallswinkel eines Laserstrahls und der Einfallswinkel des ihm zugeordneten Referenzstrahls werden jeweils so gewählt, daß der Streifenabstand des durch diese beiden Strahlen erzeugten Interferenzmusters dem Modul entspricht, der diesen beiden Strahlen zugeordnet ist. In der Figur 7 sind die Einfallswinkel der Laserstrahlen $LS_1$, $LS_2$, ..., $LS_N$ mit $\alpha_1$, $\alpha_2$ bzw. $\alpha_N$ bezeichnet, während die Einfallswinkel der zugeordneten Referenzstrahlen $RW_1$, $RW_2$ bzw. $RW_N$ mit $\beta_1$, $\beta_2$ bzw. $\beta_N$ bezeichnet sind. Speziell ist in der Figur 7 der Einfallswinkel eines Laserstrahls und der Einfallswinkel des ihm zugeordneten Referenzstrahls betragsmäßig gleich groß gewählt.

Zur Verbesserung der Signifikanz des absoluten Maximums (oder auch Minimums) für die verschiedenen Paare aus einem Laserstrahl und dem ihm zugeordneten Referenzstrahl sind verschiedene Laser zu verwenden, weil dadurch ungünstige Kohärenzeffekte ausgeschaltet werden können. Die verschiedenen Laser können auch verschiedene Wellenlängen emittieren.

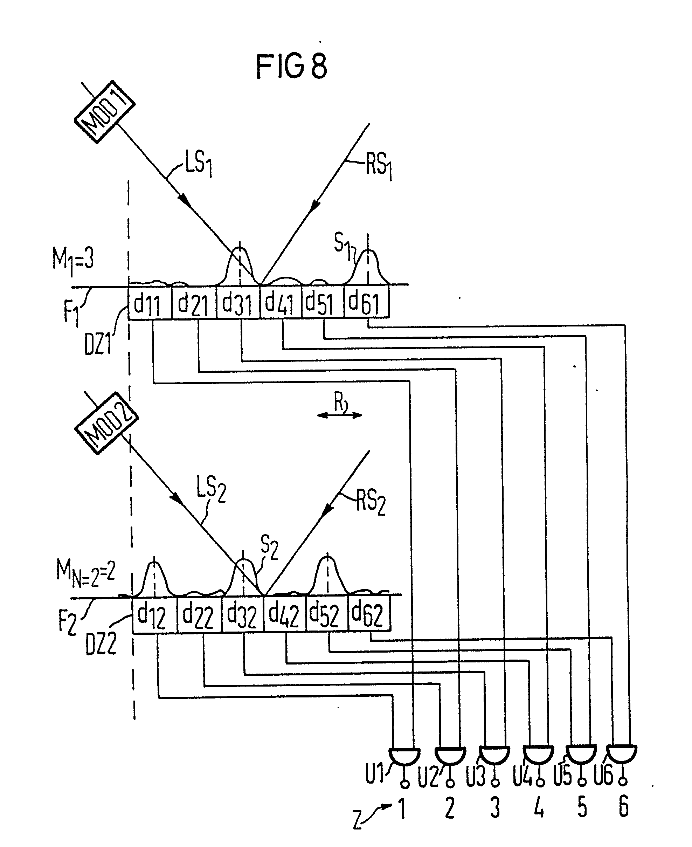

Aus der Figur 8 geht eine andere Ausführungsform einer Vorrichtung zur Umwandlung von Residuenzahlen in eine positionsnotierte Zahlendarstellung hervor. Diese Ausführungsform ist ähnlich wie bei der Vorrichtung nach Figur 3 für jeden zur gewählten Residuendarstellung verwendeten Modul je eine separate Vorrichtung zur Erzeugung einer Art stehenden Welle vorgesehen. Im Unterschied zur Vorrichtung nach Figur 3 werden jedoch bei der Vorrichtung nach Figur 8 diese stehenden Wellen nicht durch Überlagerung einer hin- und rücklaufenden Welle erzeugt, sondern durch Zweistrahlinterferenz. Dementsprechend ist für jeden Modul eine solche Zweistrahlinterferenzvorrichtung vorgesehen.

Die Figur 8 zeigt ohne Beschränkung der Allgemeinheit eine Vorrichtung zur Umwandlung von Residuenzahlen, die auf den beiden Moduln $M_1 = 3$ und $M_2 = 2$ basieren, in eine positionsnotierte Dezimaldarstellung.

Die Interferenzstreifen für den Modul $M_1$ werden durch Überlagerung eines durch einen Phasenschieber MOD1 phasenmodulierbaren Laserstrahl $LS_1$ mit einem Referenzstrahl $RS_1$ in einer Referenzebene $F_1$ erzeugt. Das entstehende Interferenzmuster, dessen Streifenabstand dem Modul $M_1$ entspricht, wird durch eine Diodenzeile abgetastet, welche $Z_{max} = 6$ Dioden $d_{11}$, $d_{21}$, $d_{31}$, $d_{41}$, $d_{51}$, $d_{61}$ enthält. Der Streifenabstand und die Größe der Dioden ist so gewählt, daß drei Dioden auf einen Streifenabstand fallen. Die Lage des Interferenzmusters $S_1$ in Figur 8 ist beispielsweise so gewählt, daß auf die Dioden $d_{31}$ und $d_{61}$ je ein Streifen, d.h. ein absolutes Intensitätsmaximum (oder auch ein absolutes Minimum) fällt.

Für den Modul $M_2$ ist eine ähnliche Vorrichtung vorgesehen, d.h. das Interferenzmuster wird durch einen mittels eines Phasenschiebers MOD2 phasenmodulierten Laserstrahl $LS_2$ und einen Referenzstrahl $RS_2$ in einer zweiten Referenzebene $F_2$ erzeugt und mittels einer Diodenzeile $DZ_2$ abgetastet, die wie die Diodenzeile $DZ_1$ sechs Dioden $d_{12}$, $d_{22}$, $d_{32}$, $d_{42}$, $d_{52}$ und $d_{62}$ enthält. Der Streifenabstand des zweiten Interferenzmusters und die Diodengröße der Zeile $DZ_2$ sind so gewählt, daß der Streifenabstand dem Modul $M_2 = 2$ entspricht und zwei Dioden auf einen Streifenabstand entfallen. Bei dem beispielhaft dargestellten zweiten Interferenzmuster $S_2$ fallen jeweils ein Streifen auf die Diode $d_{12}$, $d_{32}$ und $d_{52}$.

Eine Diode der Diodenzeile $DZ_1$ und eine Diode der Diodenzeile $DZ_2$ sind einander zugeordnet, wenn sie in der vorbestimmten Reihenfolge der Dioden in der jeweiligen Zeile an der gleichen Stelle liegen. Die Figur 8 ist so gezeichnet, daß einander zugeordnete Dioden der beiden Diodenzeilen genau untereinander liegen.

Ähnlich wie bei der Vorrichtung nach Figur 3 wird auch bei einer Vorrichtung gemäß Figur 8 eine positionsnotierte Zahl dadurch angezeigt, daß mit einer Diode einer Diodenzeile, sämtliche zugeordneten Dioden aller übrigen Diodenzeilen von einem Streifen, beispielsweise einem absoluten Intensitätsmaximum getroffen sind. Im Ausführungsbeispiel der Figur 8 ist dies für die Dioden $d_{31}$ und $d_{32}$ der beiden Diodenzeilen der Fall.

Es ist demnach für jede Diode einer Zeile festzustellen, ob mit dieser Diode auch sämtliche zugeordneten Dioden der übrigen Zeilen von einem Intensitätsmaximum getroffen werden. Dies läßt sich am einfachsten dadurch feststellen, daß die Ausgänge jeweils einander zugeordneter Dioden sämtlicher Diodenzeilen durch ein UND-Glied miteinander verbunden werden. Dabei ist vorausgesetzt, daß eine Diode nur dann ein Signal abgibt, wenn sie von einem absoluten Intensitätsmaximum (oder auch Minimum) getroffen wird.

Die Anzahl der erforderlichen UND-Glieder, in der Figur 8 mit $U_1$ bis $U_6$ bezeichnet, ist gleich der Anzahl der Dioden in einer Zeile und entspricht in der Regel der Zahl $Z_{max}$. Ordnet man jedem UND-Gatter entsprechend der Reihenfolge der Dioden in einer Zeile, mit denen sie verknüpft sind, eine Ordnungszahl von 1 bis $Z_{max}$ ($= 6$ in Figur 8) zu, so ist eine Positionsnotation gegeben. Die Ausgänge der UND-Gatter entsprechen dann den Ausgängen der Schwellwertschalter in der Ausführungsform nach Figur 7 und es kann wie dort eine Vorrichtung zur Umwandlung von positionsnotierten Dezimalzahlen in eine binäre Darstellung angeschlossen werden.

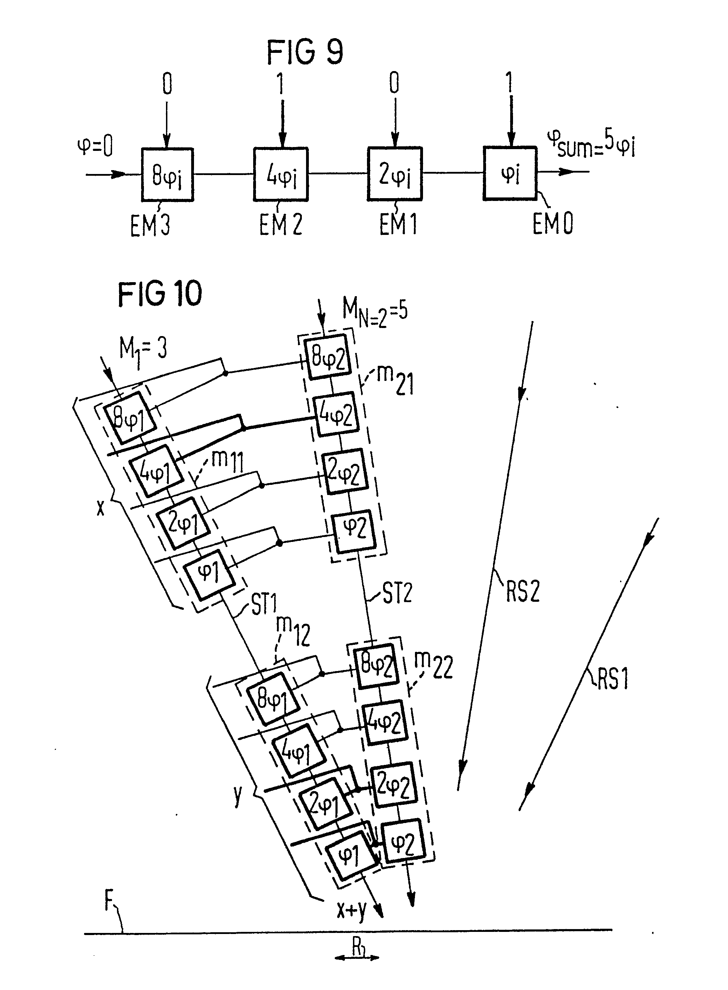

Die Figur 9 zeigt eine Vorrichtung zur Umwandlung einer Binärzahl in eine deren Wert entsprechende Phasenänderung in einem die Vorrichtung durchstrahlenden Laserstrahl. Jeder Phasenmodulator, der ein Residuum einer Residuenzahl in eine entsprechende Phasenverschiebung umzuwandeln hat, namentlich jeder der Phasenmodulatoren MOD1, MOD2, ..., MODN der Vorrichtung nach Figur 4, jeder der Phasenmodulatoren $m_{11}$, $m_{12}$, $m_{21}$, $m_{22}$ des Addierers nach Figur 6 und jeder der Phasenmodulatoren MOD1, MOD2, ..., MODN bzw. MOD1 und MOD2 in der Vorrichtung nach Figur 7 bzw. 8 kann eine Phasenmodulationsvorrichtung gemäß Figur 9 sein.

In der Vorrichtung nach Figur 9 ist für jede Binärstelle der Binärzahl je ein Einzelphasenmodulator vorgesehen und diese Einzelmodulatoren sind hintereinander im Strahlengang angeordnet. Jeder dieser Einzelmodulatoren bewirkt eine bestimmte Phasenverschiebung nur dann, wenn seine Binärstelle den Binärwert 1 aufweist. Ist der Binärwert 0, erfolgt keine Phasenänderung. Der Einzelmodulator, welcher der niedrigsten Binäroder Dualstelle der Dualzahl zugeordnet ist, erzeugt eine voreinstellbare Phasenverschiebung $\varphi_i$, wenn diese Stelle den Wert 1 hat. Der Einzelmodulator, welcher der j-ten ($j = 1, 2, ..., n$) Binärstelle der Dualzahl zugeordnet ist, muß eine Phasenverschiebung erzeugen, die gleich $2^j \cdot \varphi_i$ ist.

Bei der Vorrichtung nach Figur 9 ist eine vierstellige Dualzahl zugrundegelegt und es sind dementsprechend vier Einzelmodulatoren $EM_0$ bis $EM_3$ vorgesehen, denen die vierstellige Dualzahl parallel zuzuführen ist. Die Phasenverschiebung, die jeder dieser vier Einzelmodulatoren $EM_0$ bis $EM_3$ zu erzeugen hat, wenn der Wert der ihm zugeordneten Stelle 1 ist, ist in der Figur 9 in jedem Einzelmodulator eingetragen. Wird beispielsweise die Dualzahl 0101 zugeführt, so erzeugt der Einzelmodulator $EM_0$ die Phasenverschiebung $\varphi_i$ und der Einzelmodulator $EM_2$ die Phasenverschiebung $2^2 \cdot \varphi_i = 4\varphi_i$, während die beiden Einzelmodulatoren $EM_1$ und $EM_3$, von denen der erstgenannte die Phasenverschiebung $2^1 \cdot \varphi_i = 2 \cdot \varphi_i$ und der zweitgenannte die Phasenverschiebung $2^3 \cdot \varphi_i = 8\varphi_i$ erzeugen würde, keine Phasenverschiebung erzeugen, weil der Wert ihrer Binärstelle 0 ist. Insgesamt wird somit eine Phasenverschiebung $\varphi_{sum} = 5\varphi_i$ erzeugt.

In der Figur 10 ist ein optischer Addierer für Dualzahlen dargestellt, der das Ergebnis als positionsnotierte Zahl ausgibt. Dieser Addierer arbeitet nach dem Interferenzprinzip und er ist in gewisser Weise ähnlich aufgebaut, wie der Addierer nach Figur 6 zur Addition von Residuenzahlen.

Dem Addierer nach Figur 10 liegen zwei Moduln $M_1 = 3$ und $M_2 = 5$ zugrunde. Dem Modul $M_1$ ist ein Laserstrahl ST1 zugeordnet, der zwei Phasenmodulatoren $m_{11}$ und $m_{12}$ durchstrahlt. Dieser Laserstrahl ST1 interferiert mit einem Referenzstrahl RS1, so daß in einer Bezugsebene F ein Interferenzmuster erzeugt wird. Ein zweiter Laserstrahl ST2 ist dem Modul $M_2 = 5$ zugeordnet, und dieser durchstrahlt ebenfalls zwei Phasenmodulatoren $m_{21}$ und $m_{22}$. Dieser zweite Laserstrahl ST2 interferiert mit einem zweiten Referenzstrahl RS2, so daß in der Bezugsebene F ein zweites Interferenzmuster entsteht, das dem erstgenannten Interferenzmuster überlagert ist. Die Verwendung zweier Referenzstrahlen dient auch hier nur dazu, das absolute Maximum in dem resultierenden Interferenzmuster deutlicher herauszuheben. Die Einfallswinkel eines Laserstrahls ST1 bzw. ST2 und des ihm zugeordneten Referenzstrahls RS1 bzw. RS2 sind wieder so zu wählen, daß der Streifenabstand des von diesem Strahlenpaar erzeugten Interferenzmuster dem ihm zugeordneten Modul $M_1 = 3$ bzw. $M_2 = 5$ entspricht.

Ein wesentlicher Unterschied zwischen dem Addierer nach Figur 10 und dem Addierer nach Figur 6 liegt darin, daß beim Addierer nach Figur 10 den Phasenmodulatoren $m_{11}$, $m_{21}$ bzw. $m_{12}$ und $m_{22}$ in den beiden Laserstrahlen ST1 und ST2, die dem Summanden x bzw. y zugeordnet sind, die gleiche Zahl, nämlich dieser Summand x bzw. y, zugeführt wird. Bei dem Addierer nach Figur 6 werden dagegen den entsprechenden Phasenmodulatoren im allgemeinen verschiedene Zahlen, nämlich Residuen, zugeführt. Es müssen bei diesem Addierer somit die Summanden zuerst in Residuenzahlen umgewandelt werden.

Der Rechner nach Figur 10 addiert im Grunde genommen ebenfalls Residuenzahlen, jedoch treten diese nach außen nicht in Erscheinung. Die erforderliche Umwandlung der Summanden in Residuenzahlen wird auf äußerst einfache Weise dadurch erreicht, daß man die Phasenverschiebung der Phasenmodulatoren in Abhängigkeit von den ihnen zugeordneten Moduln richtig einstellt. Man wählt die kleinste Phasenverschiebung, die der Zahl 1 entspricht, so, daß die Zahl, die dem zugeordneten Modul entspricht, genau eine Phasenverschiebung von $2\pi$ erzeugt. Dies gilt unabhängig vom Zahlensystem, in dem die Summanden dargestellt sind.

Im Beispiel der Figur 10 wäre für die Phasenmodulatoren $m_{11}$ und $m_{12}$ die kleinste Phasenverschiebung $\varphi_1 = 2\pi/3$ zu wählen, während die kleinste Phasenverschiebung $\varphi_2$ für die beiden anderen Modulatoren $m_{21}$ und $m_{22}$ gleich $\varphi_2 = 2\pi/5$ zu wählen ist. Allgemein ist die kleinste Phasenverschiebung gleich $2\pi$ dividiert durch den zugeordneten Modul zu wählen. Auf diese Weise kann jedem Phasenmodulator, der einem bestimmten Summanden zugeordnet ist, die gleiche Zahl, namentlich der Summand, zugeführt werden, und die Umwandlung dieser Zahl in die Residuendarstellung erfolgt inhärent.

Wie schon erwähnt, ist der Addierer nach Figur 10 ein Addierer für Dualzahlen, namentlich für vierstellige Dualzahlen. Aus diesem Grunde besteht jeder der Phasenmodulatoren $m_{11}$, $m_{12}$, $m_{21}$ und $m_{22}$ aus einer Vorrichtung gemäß Figur 9 und die Summanden x und y werden in Form vierstelliger Dualzahlen parallel zugeführt.

Die Auswertung des Interferenzmusters, welches die positionsnotierte Zahl anzeigt, kann beispielsweise so erfolgen, wie in den Vorrichtungen nach den Figuren 7 oder 8.

## Patentansprüche

1. Vorrichtung zum Addieren von in ihrer Residuendarstellung in bezug auf eine Anzahl vorbestimmter Moduln ($M_i$, $i = 1$ bis $N$, $N$ = vorgebbare natürliche Zahl) dargestellten Zahlen, wobei für jeden dieser Moduln ($M_i$) je eine lineare periodische Struktur ($S_i$) konstanter Periodenlänge ($p_i$) vorgesehen ist, deren Periodenlänge gleich dem Produkt ($a \cdot M_i$) aus dem dieser Struktur zugeordneten Modul ($M_i$) mit einer Konstanten ($a$) ist, und wobei alle diese Strukturen parallel zueinander angeordnet und in ihrer Längsrichtung ($R$) relativ zueinander verschiebbar sind, dadurch gekennzeichnet, daß die linearen Strukturen ($S_i$) aus einander überlagerbaren Lichtmustern mit periodisch schwankender Intensität oder/und Mustern mit periodisch schwankender optischer Transparenz bestehen, die transversal zu ihrer Längsrichtung ($R$) auf die Lage ($Z_i$) eines Intensitätsmaximums oder -minimums in bezug auf in dieser Längsrichtung ($R$) äquidistant positionierten Detektoren ($Z$) abtastbar sind, bei denen der Abstand zwischen benachbarten Detektoren gleich der genannten Konstanten ($a$) ist.

2. Vorrichtung nach Anspruch 1, dadurch gekennzeichnet, daß die Muster mit periodisch schwankender Transparenz aus gegeneinander verschiebbaren Lochmasken bestehen, wobei bei jeder Maske der Abstand zwischen benachbarten Löchern ($M_a$) durch den dieser Maske zugeordneten Modul bestimmt ist.

3. Vorrichtung nach Anspruch 1, dadurch gekennzeichnet, daß die Lichtmuster periodischer Intensität aus stehenden Lichtwellen bestehen, wobei bei jeder stehenden Lichtwelle der Abstand ($p_i$) zwischen benachbarten Intensitätsminima oder Intensitätsmaxima durch den dieser Welle zugeordneten Modul ($M_i$) bestimmt ist, und wobei je Lichtwelle ein Phasenmodulator ($Pi$) zur Verschiebung von deren Phasenlage vorgesehen ist.

4. Vorrichtung nach Anspruch 3, dadurch gekennzeichnet, daß die stehende Lichtwelle in einem optischen Medium ($Li$) erzeugbar ist, dessen Brechungsindex veränderbar ist.

5. Vorrichtung nach Anspruch 4, dadurch gekennzeichnet, daß das optische Medium ($Li$) ein Material aufweist, in welchem eine Brechungsindexänderung durch einen in Licht induzierten Effekt erzeugbar ist.

6. Vorrichtung nach Anspruch 4 oder 5, dadurch gekennzeichnet, daß eine stehende Welle in Längsrichtung eines Streifenleiters ($Li$) ausbildbar ist, bei dem an einer quer zur Längsrichtung (R) verlaufenden Stirnfläche ein Reflektor (Mi) vorgesehen ist.

7. Vorrichtung nach Anspruch 6, dadurch gekennzeichnet, daß die stehenden Lichtwellen in Längsrichtung (R) von zueinander parallelen Lichtwellenleitern (Li) ausbildbar sind, deren Längsseiten teildurchlässig verspiegelt sind, um in transversaler Richtung einen Fabry-Perot-Resonator zu bilden, der für bestimmte Werte des Brechungsindex in transversaler Richtung lichtdurchlässig wird.

8. Vorrichtung nach einem der vorhergehenden Ansprüche, dadurch gekennzeichnet, daß ein Lichtmuster durch ein von einer Interferenzeinrichtung erzeugtes Interferenzmuster realisiert ist, und daß der Phasenmodulator (MODi; $m_{ij}$, j = 1 bis N, N ist vorgebbare natürliche Zahl) eine Einrichtung zum Verschieben der Phasenlage wenigstens einer der miteinander interferierenden Lichtwellen ($EW_i$, $RW_i$, STi, RS; $LS_i$, $RS_i$; STi, RSi) aufweist.

9. Vorrichtung nach Anspruch 8, dadurch gekennzeichnet, daß das Interferenzmuster durch Zweistrahlinterferenz erzeugt ist.

10. Vorrichtung nach Anspruch 8, dadurch gekennzeichnet, daß das Interferenzmuster durch Vielstrahlinterferenz erzeugt ist.

11. Vorrichtung nach Anspruch 10, dadurch gekennzeichnet, daß eine Interferenzeinrichtung zur Erzeugung des Interferenzmusters ein Fabry-Perot-Interferometer aufweist und daß das Interferenzmuster auf einer gewölbten Fläche erzeugt wird, auf welcher die Interferenzstreifen äquidistant sind.

12. Vorrichtung nach Anspruch 8 oder 9, dadurch gekennzeichnet, daß zur Erzeugung des Interferenzmusters je Modul ($M_i$) je ein interferierendes Lichtstrahlpaar ($EW_i$, RW; STi, RS; $LS_i$, $RW_i$, $LS_i$, $RS_i$; STi, RSi), bestehend aus einem durch einen Phasenmodulator (MODi; $m_{ij}$) phasenmodulierten Lichtstrahl ($EW_i$, $LS_i$, STi) und einem zugeordneten Referenzstrahl (RW), vorgesehen ist, daß die Strahlen sämtlicher Lichtstrahlpaare ($EW_i$, RW; STi, RS; $LS_i$, $RW_i$; $LS_i$, $RS_i$; STi, RSi) in einer Referenzfläche (F) überlagert sind, und daß die Einfallswinkel ($\alpha_i$, $\beta_j$, $\alpha_i$, $\beta_i$) der Strahlen eines jeden Paares ($EW_i$, RW; STi, RS; $LS_i$, $RW_i$; $LS_i$, $RS_i$; STi, RSi) bezüglich der Referenzfläche (F) so gewählt sind, daß der von ihnen erzeugte Streifenabstand dem zugeordneten Modul ($M_i$) entspricht.

13. Vorrichtung nach Anspruch 12, dadurch gekennzeichnet, daß sämtliche phasenmodulierbaren Lichtstrahlen ($EW_i$, STi, $LS_i$) und sämtliche Referenzstrahlen (RW, RS, $RW_i$, $RS_i$, RSi) unter verschiedenen Einfallswinkeln ($\alpha_i$, $\beta$, $\alpha_i$, $\beta_i$) einfallen.

14. Vorrichtung nach Anspruch 12 oder 13, dadurch gekennzeichnet, daß die verschiedenen Lichtstrahlenpaare ($EW_i$, RW; $RS_i$; $LS_i$, $RS_i$; STi, RSi) von verschiedenen Lichtquellen erzeugt werden.

15. Vorrichtung nach einem der Ansprüche 12 bis 14, dadurch gekennzeichnet, daß in der Referenzfläche (F) eine Diodenzeile (PDZ) zur Abtastung des Interferenzmusters vorgesehen ist, bei der jeder Diode eine positionsnotierte Zahl zugeordnet ist.

16. Vorrichtung nach Anspruch 15, dadurch gekennzeichnet, daß der Ausgang einer jeden Diode über einen Schwellwertschalter entsprechend einer vorbestimmten Zahlenkodierung mit einer Anzahl paralleler elektrischer Leitungen ($l_0$, ...$l_n$) verbunden ist, deren Anzahl ebenfalls durch die Kodierung bestimmt ist und die parallel auslesbar sind.

17. Vorrichtung nach Anspruch 9, dadurch gekennzeichnet, daß je Modul (MODi) je ein getrenntes interferierendes Lichtstrahlenpaar ($LS_i$, $RS_i$), bestehend aus einem durch einen Phasenmodulator (MODi) phasenmodulierbaren Lichtstrahl ($LS_i$) und einem zugeordneten Referenzstrahl ($RS_i$), und je eine zugeordnete Diodenzeile (DZi) zur Abtastung des zugeordneten Referenzmusters vorgesehen ist, daß in jeder Diodenzeile (DZi) einer jeden Diode ($d_{11}$, ...$d_{61}$, $d_{12}$, ...$d_{62}$) eine positionsnotierte Zahl zugeordnet ist, und daß jeweils die Dioden ($d_{11}$, $d_{21}$; ...; $d_{61}$, $d_{62}$) denen die gleiche positionsnotierte Zahl zugeordnet ist, parallel mit den Eingängen eines UND-Gliedes ($U_1$; ...$U_6$) verbunden sind, das ebenfalls dieser positionsnotierten Zahl zugeordnet ist.

18. Vorrichtung nach Anspruch 9, insbesondere zur Addition von Zahlen eines polyadischen Zahlensystems, dadurch gekennzeichnet, daß für jeden der für eine vorgewählte Residuendarstellung bestimmten Moduln ($M_i$) je ein phasenmodulierbarer Lichtstrahl (STi) vorgesehen ist, der mit einem zugeordneten Referenzstrahl (RS; RSi) ein Interferenzmuster ($S_i$) in einer zugeordneten Referenzfläche (F) erzeugt, daß die Einfallswinkel ($\alpha_i$) eines phasenmodulierbaren Lichtstrahls und des ihm zugeordneten Referenzstrahls bezüglich der zugeordneten Referenzfläche (F) so gewählt sind, daß der Streifenabstand ($p_i$) des von diesem Lichtstrahlpaar (STi, RS; STi, RSi) erzeugten Interferenzmusters in der zugeordneten Referenzfläche (F) dem diesem Lichtstrahlpaar (STi, RS; STi, RSi) zugeordneten Modul ($M_i$) entspricht, daß in jedem phasenmodulierbaren Lichtstrahl (STi) je Summand je ein Phasenmodulator ($m_{ij}$, j = 1 bis Zahl der Summanden) angeordnet ist, der eine Phasenverschiebung in Abhängigkeit von dem Zahlenwert des ihm zugeordneten Summanden erzeugt, die gleich einem diesem Zahlenwert entsprechenden Vielfachen einer vorgewählten kleinsten Phasenverschiebung ist, und daß bei jedem Phasenmodulator ($m_{ij}$) diese kleinste Phasenverschiebung gleich $2\pi$ dividiert durch den zugeordneten Modul ($M_i$) gewählt ist, wobei das Ergebnis aus dem oder den Interferenzmustern ($S_i$) als positionsnotierte Zahl hervorgeht.

19. Vorrichtung nach Anspruch 18, dadurch gekennzeichnet, daß die zugeordnete Referenzfläche (F) eine allen Lichtstrahlen und Referenzstrahlen gemeinsame zugeordnete Fläche ist, in der alle diese Strahlen überlagert sind.

## Claims

1. Device for adding numbers represented in their residual representation in relation to a number of predetermined modules ($M_i$, i = 1 to N, N = definable natural number), for each of these modules ($M_i$) being provided in each case one linear periodic structure ($S_i$) of constant period length ($p_i$), the period length of which is equal to the product (a . $M_i$) of the module ($M_i$) associated with this structure and a constant (a), and all these structures being arranged parallel to one another and being shiftable in their longitudinal direction (R) relative to one another, characterized in that the linear structures ($S_i$) consist of mutually superimposable light patterns with periodically fluctuating intensity or/and patterns with periodically fluctuating optical transparency, which can be sampled transversely to their longitudinal direction (R) for the position ($Z_i$) of an intensity maximum or intensity minimum with respect to detectors positioned equidistantly in this longitudinal direction (R), in which the distance between adjacent detectors is equal to the stated constant (a).

2. Device according to Claim 1, characterized in that the patterns with periodically fluctuating transparency consist of hole masks which can be mutually shifted, the distance between adjacent holes ($M_a$) being determined for each mask by the module associated with this mask.

3. Device according to Claim 1, characterized in that the light patterns of periodic intensity consist of stationary light waves, the distance ($p_i$) between adjacent intensity minima or intensity maxima being determined for each stationary light wave by the module ($M_i$) associated with this wave, and a phase modulator ($P_i$) being provided for each light wave for shifting the phase position thereof.

4. Device according to Claim 3, characterized in that the stationary light wave can be produced in an optical medium ($L_i$), the refractive index of which can be altered.

5. Device according to Claim 4, characterized in that the optical medium ($L_i$) exhibits a material in which a change of refractive index can be produced by an effect induced in light.

6. Device according to Claim 4 or 5, characterized in that a stationary wave can be formed in the longitudinal direction of a strip line ($L_i$), in which a reflector ($M_i$) is provided on an end face extending transversely to the longitudinal direction (R).

7. Device according to Claim 6, characterized in that the stationary light waves can be formed in the longitudinal direction (R) of mutually parallel optical waveguides ($L_i$), the longitudinal sides of which are mirrored so as to be semi-reflective in order to form in the transverse direction a Fabry-Perot resonator which becomes permeable to light in the transverse direction for defined values of the refractive index.

8. Device according to one of the preceding claims, characterized in that a light pattern is realized by an interference pattern produced by an interference device, and in that the phase modulator ($MOD_i$; $m_{ij}$, j = 1 to N, N is a definable natural number) exhibits a device for shifting the phase position of at least one of the mutually interfering light waves ($EW_i$, $RW_i$, STi, RS; $LS_i$, $RS_i$; STi, RSi).

9. Device according to Claim 8, characterized in that the interference pattern is produced by two-beam interference.

10. Device according to Claim 8, characterized in that the interference pattern is produced by multi-beam interference.

11. Device according to Claim 10, characterized in that an interference device exhibits a Fabry-Perot interferometer for producing the interference pattern, and in that the interference pattern is produced on a curved surface on which the interference strips are equidistant.

12. Device according to Claim 8 or 9, characterized in that, for producing the interference pattern, one interfering pair of light beams ($EW_i$, RW; STi, RS; $LS_i$, $RW_i$, $LS_i$, $RS_i$; STi, RSi), consisting of a light beam ($EW_i$, $LS_i$, STi) phase-modulated by a phase modulator ($MOD_i$; $m_{ij}$) and of an associated reference beam (RW), is in each case provided for each module ($M_i$), in that the beams of all pairs of light beams ($EW_i$, RW; STi, RS; LSi, $RW_i$; $LS_i$; $RS_i$; STi, RSi) are superimposed in a reference surface (F), and in that the angles of incidence ($\alpha_i$, $\beta_i$, $\alpha_i$, $\beta_i$) of the beams of each pair ($EW_i$, RW; STi, RS; $LS_i$, $RW_i$; $LS_i$, $RS_i$, STi, RSi) are selected in relation to the reference surface (F) in such a manner that the strip distance produced by them corresponds to the associated module ($M_i$).

13. Device according to Claim 12, characterized in that all phase-modulatable light beams ($EW_i$, STi, $LS_i$) and all reference beams (RW, RS, $RW_i$, $RS_i$, RSi) are incident at different angles of incidence ($\alpha_i$, $\beta$, $\alpha_i$, $\beta_i$).

14. Device according to Claim 12 or 13, characterized in that the different pairs of light beams ($EW_i$, RW; $RS_i$; $LS_i$, $RS_i$; STi, RSi) are produced by different light sources.

15. Device according to one of Claims 12 ot 14, characterized in that, for sampling the interference pattern, in the reference surface (F) a diode row (PDZ) is provided in which a positional notation number is associated with each diode.

16. Device according to Claim 15, characterized in that the output of each diode is connected via a threshold value switch in accordance with a predetermined number coding to a number of parallel electrical lines ($1_0$, ...$1_n$), the number of which is likewise determined by the coding and which can be read out in parallel.

17. Device according to Claim 9, characterized in that for each module ($MOD_i$) there is provided in each case a separate interfering pair of light beams ($LS_i$, $RS_i$), consisting of a light beam ($LS_i$) which can be phase-modulated by a phase modulator ($MOD_i$) and of an associated reference beam ($RS_i$), and in each case an associated diode row ($DZi$) for sampling the associated reference pattern, in that in each diode row ($DZi$) a positional notation number is associated with each diode

$(d_{11}, ...d_{61}, d_{12}, ...d_{62})$, and in that in each case the diodes $(d_{11}, d_{21}; ...; d_{61}, d_{62})$ which are associated with the same positional notation number are connected in parallel to the inputs of an AND element $(U_1; ...U_6)$, which is likewise associated with this positional notation number.

18. Device according to Claim 9, in particular for adding the numbers of a polyadic number system, characterized in that there is provided for each of the modules $(M_i)$ defined for a preselected residual representation in each case a phase-modulatable light beam (STi) which produces with an associated reference beam (RS; RSi) an interference pattern $(S_i)$ in an associated reference surface (F), in that the angles of incidence $(\alpha_i)$ of a phase-modulatable light beam and the reference beam associated therewith is selected with reference to the associated reference surface (F) in such a manner that the strip distance $(p_i)$ of the interference pattern produced by the said pair of light beams (STi, RS; STi, RSi) in the associated reference surface (F) corresponds to the module $(M_i)$ associated with this pair of light beams (STi, RS; STi, RSi), in that there is arranged in each phase-modulatable light beam (STi) in each case per summand a phase modulator $(m_{ij}, j = 1$ to number of summands), which produces a phase shift as a function of the number value of the summand associated therewith which is equal to a multiple, corresponding to this number value, of a preselected smallest phase shift, and in that in each phase modulator $(m_{ij})$ this smallest phase shift is selected to be equal to $2\pi$ divided by the associated module $(M_i)$, the result being obtained from the interference pattern(s) $(S_i)$ as a positional notation number.

19. Device according to Claim 18, characterized in that the associated reference surface (F) is an associated surface common to all light beams and reference beams, in which surface all these beams are superimposed.

## Revendications

1. Dispositif pour additionner des nombres dans leur représentation sous forme de résidus par rapport à un certain nombre de modules prédéterminés $(M_i, i = 1$ à N, N = un nombre naturel pouvant être préfixé), avec prévision pour chacun de ces modules $(M_i)$ d'une structure périodique linéaire $(S_i)$ de longueur de période $(p_i)$ constante, la longueur de période étant égale au produit (a . $M_i$) du module $(M_i)$ coordonné à cette structure et d'une constante (a), toutes ces structures étant disposées en parallèle entre elles et pouvant être décalées les unes par rapport aux autres dans leur direction longitudinale (R), caractérisé en ce que les structures linéaires $(S_i)$ sont formées de figures lumineuses susceptibles d'être superposées, dont l'intensité varie périodiquement, et/ou de figures dont la transparence optique varie périodiquement, qui peuvent être explorées, transversalement à leur direction longitudinale (R), sur la position $(Z_i)$ d'un maximum ou d'un minimum d'intensité par rapport à des détecteurs (Z) disposés à des distances égales dans cette direction longitudinale (R), la distance entre des détecteurs voisins étant égale à la constante (a) mentionnée.

2. Dispositif selon la revendication 1, caractérisé en ce que les figures dont la transparence varie périodiquement, sont formées par des masques perforés pouvant être déplacés l'un par rapport à l'autre, la distance entre des trous $(M_a)$ voisins étant déterminée, sur chaque masque, par le module coordonné à ce masque.

3. Dispositif selon la revendication 1, caractérisé en ce que les figures lumineuses dont l'intensité varie périodiquement, sont formées par des ondes lumineuses stationnaires, la distance $(p_i)$ entre des minima ou des maxima d'intensité voisins étant déterminée, pour chaque onde stationnaire, par le module $(M_i)$ coordonné à cette onde et un modulateur de phase $(P_i)$ étant prévu pour chaque onde lumineuse en vue du décalage de sa position de phase.

4. Dispositif selon la revendication 3, caractérisé en ce que l'onde lumineuse stationnaire peut être produite dans un milieu optique (Li) dont l'indice de réfraction peut être changé.

5. Dispositif selon la revendication 4, caractérisé en ce que le milieu optique (Li) présente un matériau dans lequel un changement de l'indice de réfraction peut être produit par un effet induit par la lumière.

6. Dispositif selon la revendication 4 ou 5, caractérisé en ce qu'une onde stationnaire peut être formée dans la direction longitudinale d'un guide d'ondes à ruban (Li), sur lequel un réflecteur (Ri) est prévu sur une face frontale s'étendant transversalement à la direction longitudinale (R).

7. Dispositif selon la revendication 6, caractérisé en ce que les ondes lumineuses stationnaires peuvent être produites dans la direction longitudinale (R) de guides d'ondes lumineuses (Li) qui sont parallèles entre eux et dont les côtés longitudinaux sont rendus miroitants/semi-transparents pour former, en direction transversale, un résonateur de Fabry et Pérot qui devient translucide en direction transversale pour des valeurs déterminées de l'indice de réfraction.

8. Dispositif selon une des revendications précédentes, caractérisé en ce qu'une figure lumineuse est formée par une figure d'interférence créée par un dispositif d'interférence et que le modulateur de phase (MODi; $m_{ij}, j = 1$ à N, N étant un nombre naturel pouvant être préfixé) présente un dispositif pour décaler la position de phase d'au moins l'une des ondes lumineuses $(EW_i, RW_i,$ STi, RS; $LS_i, RS_i$; STi, RSi) interférant entre elles.

9. Dispositif selon la revendication 8, caractérisé en ce que la figure d'interférence est créée par l'interférence de deux rayons.

10. Dispositif selon la revendication 8, caractérisé en ce que la figure d'interférence est créée par l'interférence de multiples rayons.

11. Dispositif selon la revendication 10, caractérisé en ce qu'un dispositif d'interférence pour la création de la figure d'interférence, comprend un interféromètre de Fabry et Pérot et que la figure d'interférence est créée sur une surface bombée, sur laquelle les franges d'interférence sont équidistantes.

12. Dispositif selon la revendication 8 ou 9, caractérisé en ce que, pour la création de la figure d'interférence, on a prévu, pour chaque module $(M_i)$, une paire de rayons lumineux $(EW_i, RW; STi, RS; LS_i, RW_i, LS_i, RS_i; STi, RSi)$ qui interfèrent, constituée d'un rayon lumineux $(EW_i, LS_i, STi)$ modulé en phase par un modulateur de phase $(MODi; m_{ij})$ et par un rayon de référence $(RW)$ coordonné, que les rayons de toutes les paires de rayons lumineux $(EW_i, RW; STi, RS; LS_i, RW_i; LS_i, RS_i; STi, RSi)$ sont superposés dans une surface de référence $(F)$ et que les angles d'incidence $(\alpha_i, \beta_i, \alpha_i, \beta_i)$ des rayons de chaque paire $(EW_i, RW; STi, RS; LS_i, RW_i; LS_i, RS_i, STi, RSi)$ par rapport à la surface de référence $(F)$, sont choisis de manière que l'interfrange établi par eux corresponde au module $(M_i)$ coordonné.

13. Dispositif selon la revendication 12, caractérisé en ce que tous les rayons lumineux $(EW_i, STi, LS_i)$ modulables en phase et tous les rayons de référence $(RW, RS, RW_i, RS_i, RSi)$ ont des angles d'incidence $(\alpha_i, \beta, \alpha_i, \beta_i)$ différents.

14. Dispositif selon la revendication 12 ou 13, caractérisé en ce que les différentes paires de rayons lumineux $(EW_i, RW; RS_i; LS_i, RS_i; STi, RSi)$ sont produites par différentes sources lumineuses.

15. Dispositif selon une des revendications 12 à 14, caractérisé en ce qu'une ligne de diodes (PDZ) pour l'exploration de la figure d'interférence est prévue dans la surface de référence $(F)$, avec coordination d'un nombre à notation positionnelle à chaque diode.

16. Dispositif selon la revendication 15, caractérisé en ce que la sortie de chaque diode est reliée à travers un interrupteur à seuil et conformément à un codage de nombres prédéterminé, à un certain nombre de lignes électriques parallèles $(I_0, ...I_n)$ dont le nombre est également déterminé par le codage et qui peuvent être lues en parallèle.

17. Dispositif selon la revendication 9, caractérisé en ce que, pour chaque module (MODi), on a prévu une paire séparée de rayons lumineux $(LS_i, RS_i)$ qui interfèrent, constituée d'un rayon lumineux $(LS_i)$ modulable en phase par un modulateur de phase (MODi) et d'un rayon de référence $(RS_i)$ coordonné et, pour l'exploration de la figure d'interférence coordonnée, on a prévu chaque fois une ligne de diodes (DZi) coordonnée, qu'un nombre à notation positionnelle est coordonné à chaque diode $(d_{11}, ...d_{61}, d_{12}, ...d_{62})$ dans chaque ligne de diodes (DZi) et que les diodes $(d_{11}, d_{21}; ...; d_{61}, d_{62})$ auxquelles est coordonné le même nombre à notation positionnelle, sont reliées en parallèle aux entrées d'un élément ET $(U_1; ...U_6)$ qui est également coordonné à ce nombre à notation positionnelle.

18. Dispositif selon la revendication 9, en particulier pour l'addition de nombres d'un système de nombres polyadique, caractérisé en ce que, pour chacun des modules $(M_i)$ destinés à une représentation présélectionnée sous forme de résidus, on a prévu un rayon lumineux (STi) modulable en phase et qui, avec un rayon de référence (RS; RSi) coordonné, crée une figure d'interférence $(S_i)$ dans une surface de référence $(F)$ coordonnée, que les angles d'incidence $(\alpha_i)$ d'un rayon lumineux modulable en phase et du rayon de référence qui lui est coordonné, par rapport à la surface de référence $(F)$ coordonnée, sont choisis de manière que l'interfrange $(p_i)$ de la figure d'interférence créée par cette paire de rayons lumineux (STi, RS; STi, RSi) dans la surface de référence $(F)$ coordonnée, corresponde au module $(M_i)$ coordonné à cette paire de rayons lumineux (STi, RS; STi, RSi) qu'un modulateur de phase $(m_{ij}, j = 1$ jusqu'au nombre des termes de l'addition) est disposé pour chaque terme de l'addition dans chaque rayon lumineux (STi) modulable en phase, modulateur qui produit un déphasage en fonction de la valeur numérique du terme de l'addition qui lui est coordonné, le déphasage étant égal à un multiple, correspondant à cette valeur numérique, d'un déphasage minimal présélectionné, et que, pour chaque modulateur de phase $(m_{ij})$, ce déphasage minimal est choisi égal à $2\pi$ divisé par le module $(M_i)$ coordonné, le résultat ressortant comme un nombre à notation positionnelle de la figure ou des figures d'interférence $(S_i)$.

19. Dispositif selon la revendication 18, caractérisé en ce que la surface de référence $(F)$ coordonnée est une surface commune coordonnée à tous les rayons lumineux et tous les rayons de référence et dans laquelle tous ces rayons sont superposés.

FIG 1

# FIG 2

FIG 3

# FIG 4

# FIG 5

FIG 6

# FIG 7

# FIG 8

## FIG 9

## FIG 10